# EUROPEAN PATENT APPLICATION

(11) **EP 4 675 686 A1**
(43) Date of publication of application: **07.01.2026**
(21) Application number: 24763993.3
(22) Date of filing: 28.02.2024
(51) Int. Cl.: H01L 31/042, H02S 40/34

(54) **ENERGY HARVESTER AND METHOD FOR MANUFACTURING SAME**

(30) Priority: 28.02.2023 JP 2023030528
(71) Applicant: Zeon Corporation, Tokyo 100-8246 (JP)
(72) Inventor: MATSUSHIMA, Noriaki, Tokyo 100-8246 (JP)
(74) Representative: Maiwald GmbH
(86) International application number: PCT/JP2024/007414
(87) International publication number: WO 2024/181516

(57) **Abstract**

An energy harvester includes a first conductive substrate layer (2), a current collector layer (3), a sealing material layer (4), and a second conductive substrate layer (5) in stated order. The energy harvester includes: a power generation section that includes a peripheral portion (6a) formed by the first conductive substrate layer (2), the current collector layer (3), the sealing material layer (4), and the second conductive substrate layer (5) and that converts energy of an external environment to electrical power; and an output section (7) that is disposed outside of the power generation section and that is formed by the first conductive substrate layer (2) and the current collector layer (3). The output section (7) includes a first portion (3a) of the current collector layer (3) where the electrical power from the power generation section is supplied, a second portion (3b) of the current collector layer (3) that is separated from the first portion (3a), an electronic component (8) that electrically connects the first portion (3a) and the second portion (3b), and a sealing material (9) that seals the electronic component (8).

## Description

### TECHNICAL FIELD

The present disclosure relates to an energy harvester and a method of producing the same.

### BACKGROUND

In a known energy harvester including a first conductive substrate layer, a current collector layer, a sealing material layer, and a second conductive substrate layer in stated order, the energy harvester includes a power generation section that includes a peripheral portion formed by the first conductive substrate layer, the current collector layer, the sealing material layer, and the second conductive substrate layer and that converts energy of an external environment to electrical power and also includes an output section that is disposed outside of the power generation section and that is formed by the first conductive substrate layer and the current collector layer (for example, refer to Patent Literature (PTL) 1).

### CITATION LIST

### Patent Literature

PTL 1: WO2019/188433A1

### SUMMARY

### (Technical Problem)

When an electronic component is provided in an output section of an energy harvester such as described above with an object such as inhibiting reverse flow of electrical current, it is preferable to adopt a configuration that can restrict thickness of the energy harvester as much as possible.

An object of the present disclosure is to provide an energy harvester that enables the provision of an electronic component in an output section while also restricting thickness of the energy harvester and also to provide a method of producing the same.

### (Solution to Problem)

One aspect of the present disclosure is as follows.
[1] An energy harvester comprising a first conductive substrate layer, a current collector layer, a sealing material layer, and a second conductive substrate layer in stated order, wherein
   the energy harvester includes:
   a power generation section that includes a peripheral portion formed by the first conductive substrate layer, the current collector layer, the sealing material layer, and the second conductive substrate layer and that converts energy of an external environment to electrical power; and
   an output section that is disposed outside of the power generation section and that is formed by the first conductive substrate layer and the current collector layer, and
   the output section includes a first portion of the current collector layer where the electrical power from the power generation section is supplied, a second portion of the current collector layer that is separated from the first portion, an electronic component that electrically connects the first portion and the second portion, and a sealing material that seals the electronic component.
[2] The energy harvester according to [1], wherein the second conductive substrate layer is disposed such as to not overlap with the electronic component in a stacking direction.
[3] The energy harvester according to [1] or [2], wherein the electronic component inhibits reverse flow of electrical current between the first portion and the second portion of the current collector layer.
[4] The energy harvester according to [3], wherein the electronic component is a diode.
[5] The energy harvester according to any one of [1] to [4], wherein the sealing material is continuously formed using the same material in the sealing material layer.
[6] The energy harvester according to any one of [1] to [5], wherein
   the output section includes a pair of output electrodes formed by the current collector layer, and
   at least one of the output electrodes is formed by the second portion of the current collector layer and a metal layer that is stacked on the second portion of the current collector layer such as to be positioned at an opposite side to the first conductive substrate layer.
[7] The energy harvester according to [6], wherein the power generation section includes a power-generating cell group that is formed of a plurality of power-generating cells that electrically connect the pair of output electrodes to each other.
[8] The energy harvester according to [7], wherein
   the power-generating cell group includes a first power-generating cell row that is formed of a plurality of power-generating cells that are electrically connected to one another in series and a second power-generating cell row that is formed of a plurality of power-generating cells that are electrically connected to one another in series, and
   the power generation section includes a current-collecting material that electrically connects the first power-generating cell row and the second power-generating cell row to each other.
[9] The energy harvester according to [8], wherein the current-collecting material is formed by the current collector layer.
[10] The energy harvester according to any one of [6] to [9], wherein
   a first barrier layer, the first conductive substrate layer, the current collector layer, the sealing material layer, the second conductive substrate layer, and a second barrier layer are included in stated order, and
   the sealing material, the second conductive substrate layer, and the second barrier layer are disposed such as to not overlap with at least part of the metal layer of each of the output electrodes in a stacking direction.
[11] The energy harvester according to any one of [1] to [10], wherein the power generation section converts light energy of the external environment to the electrical power.
[12] The energy harvester according to any one of [1] to [11], wherein
   an adhesive layer is stacked between the electronic component and the first portion of the current collector layer and between the electronic component and the second portion of the current collector layer, and
   the adhesive layer electrically connects the electronic component to the first portion of the current collector layer and the second portion of the current collector layer.
[13] The energy harvester according to [12], wherein the adhesive layer is formed by an anisotropic conductive film.
[14] The energy harvester according to any one of [1] to [13], wherein the energy harvester has a flat surface-shaped external form or a curved surface-shaped external form.
[15] A method of producing the energy harvester according to any one of [1] to [14], comprising sealing in which the sealing material layer and the sealing material are continuously formed using the same material.
[16] The method according to [15], comprising electronic component arrangement in which the electronic component is electrically connected to the first portion of the current collector layer and the second portion of the current collector layer, wherein
   the sealing is performed after the electronic component arrangement.
[17] The method according to [15] or [16], comprising:
   first barrier layer stacking in which a first barrier layer and the first conductive substrate layer are stacked; and
   second barrier layer stacking in which a second barrier layer and the second conductive substrate layer are stacked, wherein
   the sealing is performed after the first barrier layer stacking and after the second barrier layer stacking, and
   the energy harvester includes the first barrier layer, the first conductive substrate layer, the current collector layer, the sealing material layer, the second conductive substrate layer, and the second barrier layer in stated order.

### (Advantageous Effect)

According to the present disclosure, it is possible to provide an energy harvester that enables the provision of an electronic component in an output section while also restricting thickness of the energy harvester and also to provide a method of producing the same.

### BRIEF DESCRIPTION OF THE DRAWINGS

In the accompanying drawings:
FIG. 1 is a plan view illustrating an energy harvester of one embodiment of the present disclosure; and
FIG. 2 is a cross-sectional view at A-A.

### DETAILED DESCRIPTION

The following refers to the drawings to provide an illustrative description of an embodiment of the present disclosure.

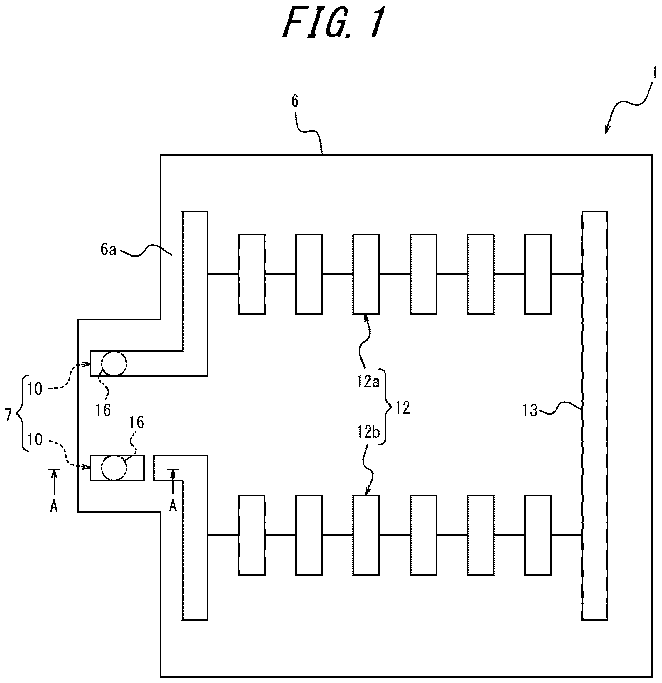

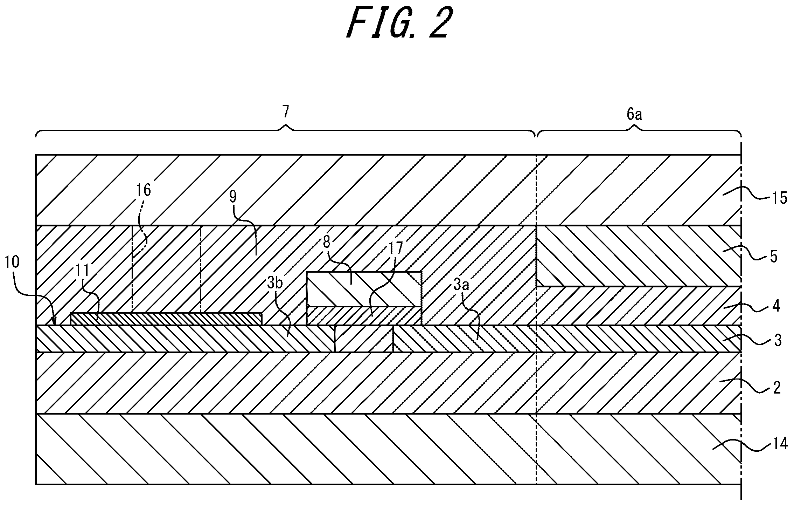

As illustrated in FIGS. 1 and 2, an energy harvester 1 in one embodiment of the present disclosure is an energy harvester 1 including a first conductive substrate layer 2, a current collector layer 3, a sealing material layer 4, and a second conductive substrate layer 5 in stated order, wherein the energy harvester 1 includes a power generation section 6 that includes a peripheral portion 6a formed by the first conductive substrate layer 2, the current collector layer 3, the sealing material layer 4, and the second conductive substrate layer 5 and that converts energy of an external environment to electrical power and an output section 7 that is disposed outside of the power generation section 6 and that is formed by the first conductive substrate layer 2 and the current collector layer 3, and the output section 7 includes a first portion 3a of the current collector layer 3 where electrical power from the power generation section 6 is supplied, a second portion 3b of the current collector layer 3 that is separated from the first portion 3a, an electronic component 8 that electrically connects the first portion 3a and the second portion 3b, and a sealing material 9 that seals the electronic component 8.

Through the configuration set forth above, it is possible to restrict thickness of the energy harvester 1 as a result of the electronic component 8 being arranged such as to electrically connect the first portion 3a of the current collector layer 3 and the second portion 3b of the current collector layer 3, and it is possible to ensure stable operation of the electronic component 8 as a result of the electronic component 8 being sealed by the sealing material 9. Therefore, through the configuration set forth above, it is possible to realize an energy harvester 1 that enables the provision of an electronic component 8 in an output section 7 while also restricting thickness of the energy harvester 1. Moreover, through the configuration set forth above, it is possible to inhibit infiltration of moisture or the like to inside of the power generation section 6 as a result of thickness at the periphery of the energy harvester 1 being restricted. The current collector layer 3 may be formed using a silver paste, for example.

The second conductive substrate layer 5 is disposed such as to not overlap with the electronic component 8 in a stacking direction. Through the configuration set forth above, it is possible to further restrict thickness of the energy harvester 1.

The electronic component 8 inhibits reverse flow of electrical current between the first portion 3a and the second portion 3b of the current collector layer 3. Through the configuration set forth above, it is possible to inhibit reverse flow of electrical current in the output section 7 through the electronic component 8.

An anode of the electronic component 8 is electrically connected to the power generation section 6 via the first portion 3a of the current collector layer 3, and a cathode of the electronic component 8 is electrically connected to a device external to the energy harvester 1 via the second portion 3b of the current collector layer 3. Through the configuration set forth above, it is possible to increase stability of operation of the electronic component 8.

The electronic component 8 is a diode. Through the configuration set forth above, it is possible to simplify the structure of the electronic component 8 that inhibits reverse flow of electrical current.

The sealing material 9 is continuously formed using the same material in the sealing material layer 4. Through the configuration set forth above, it is possible to improve sealing performance against moisture and the like at the periphery of the power generation section 6. Moreover, through the configuration set forth above, it is possible to simplify production steps since the sealing material layer 4 and the sealing material 9 can be formed in the same step. The sealing material 9 and/or the sealing material layer 4 preferably displays light transmittance. The sealing material 9 and/or the sealing material layer 4 can be formed using a thermoplastic resin, a thermosetting resin, or an active radiation (light or electron beam) curable resin, for example, and can, more specifically, be formed using an acrylic resin, a methacrylic resin, a fluororesin, a silicone resin, an olefin resin, a polyamide resin, or the like. Note that one of these materials may be used individually, or two or more of these materials may be used in combination.

The output section 7 includes a pair of output electrodes 10 formed by the current collector layer 3, and at least one of the output electrodes 10 is formed by the second portion 3b of the current collector layer 3 and a metal layer 11 that is stacked on the second portion 3b of the current collector layer 3 such as to be positioned at an opposite side to the first conductive substrate layer 2. Through the configuration set forth above, it is possible to reduce electrical resistance at a contact of the output section 7 and improve output performance as a result of the metal layer 11 being used as a contact of the output section 7.

The power generation section 6 includes a power-generating cell group 12 that is formed of a plurality of power-generating cells that electrically connect the pair of output electrodes 10 to each other. Through the configuration set forth above, it is possible to efficiently realize desired power generation performance.

The power-generating cell group 12 includes a first power-generating cell row 12a that is formed of a plurality of power-generating cells that are electrically connected to one another in series and a second power-generating cell row 12b that is formed of a plurality of power-generating cells that are electrically connected to one another in series, and the power generation section 6 includes a current-collecting material 13 that electrically connects the first power-generating cell row 12a and the second power-generating cell row 12b to each other. Through the configuration set forth above, it is possible to efficiently improve power generation voltage.

The power-generating cells of the power-generating cell group 12 are solar cells. Through the configuration set forth above, it is possible to configure the energy harvester 1 as a solar module.

The power-generating cells of the power-generating cell group 12 may be dye-sensitized solar cells, for example. The dye-sensitized solar cells may generate power by causing a dye that is adsorbed onto porous titania to absorb light and generate electrons.

The current-collecting material 13 is formed by the current collector layer 3. Through the configuration set forth above, it is possible simplify the structure of the current-collecting material 13. Moreover, through the configuration set forth above, it is possible to simplify production steps.

The current collector layer 3 may be formed using a conductive paste, for example. The conductive paste may be a mixture of conductive particles and a resin, for example. The conductive particles of the conductive paste forming the current collector layer 3 may be copper, silver, carbon, or the like, for example, without any specific limitations. The current collector layer 3 may alternatively be formed by affixing metal foil through a conductive adhesive or the like.

In the energy harvester 1, a first barrier layer 14, the first conductive substrate layer 2, the current collector layer 3, the sealing material layer 4, the second conductive substrate layer 5, and a second barrier layer 15 are included in stated order, and the sealing material 9, the second conductive substrate layer 5, and the second barrier layer 15 are disposed such as to not overlap with at least part of the metal layer 11 of each of the output electrodes 10 in a stacking direction. Through the configuration set forth above, it is possible to use the metal layer 11 provided in each of the output electrodes 10 as a contact of the output section 7, and it is possible to inhibit infiltration of moisture or the like to inside of the power generation section 6 through the first barrier layer 14 and the second barrier layer 15. The water vapor permeability of the first barrier layer 14 and the second barrier layer 15 is preferably 0.1 g/m²/day or less, more preferably 0.01 g/m²/day or less, even more preferably 0.0005 g/m²/day or less, and particularly preferably 0.0001 g/m²/day or less in an environment having a temperature of 40°C and a relative humidity of 90% (90% RH). The total luminous transmittance of the first barrier layer 14 and the second barrier layer 15 is preferably 50% or more, more preferably 70% or more, and even more preferably 85% or more. This total luminous transmittance can be measured according to JIS K7361-1, for example. The first barrier layer 14 and the second barrier layer 15 can each be a film or thin plate where a barrier layer having low water vapor or gas permeability is provided on a plastic support. The barrier film having low water vapor or gas permeability may be a film obtained through vapor deposition of silicon oxide or aluminum oxide, a film including an organic-inorganic hybrid coating layer, a film including an inorganic layered compound, a film in which inorganic materials are stacked, a film in which organic and inorganic layers are alternately stacked, or a film in which organic and inorganic layers are successively stacked. The first barrier layer 14 and the second barrier layer 15 may be provided with cut-off functionality in order to cut off light of a specific wavelength such as ultraviolet light, antifouling functionality in order to prevent surface dirt, hard coat functionality in order to prevent surface scratching, or the like, as necessary.

The energy harvester 1 may have a configuration including a pair of holes 16 composed of one hole 16 that at least partially exposes the metal layer 11 of one of the output electrodes 10 and another hole 16 that at least partially exposes the metal layer 11 of the other of the output electrodes 10. Through the configuration set forth above, it is possible to use the metal layers 11 of the output electrodes 10 as contacts of the output section 7 through the pair of holes 16. The holes 16 may be replaced with notches, for example.

The power generation section 6 converts light energy of an external environment to electrical power. Through the configuration set forth above, it is possible to configure the energy harvester 1 as a photovoltaic body.

In the energy harvester 1, an adhesive layer 17 is stacked between the electronic component 8 and the first portion 3a of the current collector layer 3 and between the electronic component 8 and the second portion 3b of the current collector layer 3, the adhesive layer 17 is in contact with the electronic component 8, the first portion 3a, and the second portion 3b, and the adhesive layer 17 electrically connects the electronic component 8 to the first portion 3a of the current collector layer 3 and the second portion 3b of the current collector layer 3. Through the configuration set forth above, it is possible to further restrict thickness of the energy harvester 1. Note that the arrangement of the electronic component 8 is not limited to that described above. For example, a configuration in which the adhesive layer 17 is stacked on the first conductive substrate layer 2 rather than being stacked on the first portion 3a and the second portion 3b of the current collector layer 3, in which the adhesive layer 17 is in contact with the electronic component 8, the first conductive substrate layer 2, the first portion 3a, and the second portion 3b, and in which the electronic component 8 is electrically connected to the first portion 3a via the adhesive layer 17 and the electronic component 8 is electrically connected to the second portion 3b via the adhesive layer 17 may be adopted.

The adhesive layer 17 may be formed by an anisotropic conductive film (ACF) or the like. Through the configuration set forth above, it is possible to simplify production steps. The adhesive layer 17 may be formed using a silver paste, for example.

No specific limitations are placed on the external form of the energy harvester 1. The energy harvester 1 may be configured such as to have a flat surface-shaped external form or may be configured such as to have a curved surface-shaped external form, for example. The thickness of the energy harvester 1 is 0.3 mm to 5 mm, preferably 0.5 mm to 3 mm, and more preferably 0.6 mm to 1.5 mm.

In a case in which the energy harvester 1 uses vibration as energy of an external environment, a configuration in which the power generation section 6 includes a piezoelectric component that converts vibration to electrical power may be adopted, for example. In a case in which the energy harvester 1 uses geothermal energy as energy of an external environment, a configuration in which the power generation section 6 includes a heat exchange component that converts heat to electrical power may be adopted, for example.

The energy harvester 1 may be produced through a production method that includes a sealing step in which the sealing material layer 4 and the sealing material 9 are continuously formed using the same material. Through the configuration set forth above, it is possible to realize a method of producing an energy harvester 1 that enables the provision of an electronic component 8 in an output section 7 while also restricting thickness of the energy harvester 1. Moreover, through the configuration set forth above, it is possible to simplify production steps since the sealing material layer 4 and the sealing material 9 can be formed in the same step.

A configuration in which the production method of the energy harvester 1 includes an electronic component 8 arrangement step in which the electronic component 8 is electrically connected to the first portion 3a of the current collector layer 3 and the second portion 3b of the current collector layer 3 and in which the sealing step is performed after the electronic component 8 arrangement step may be adopted. Through the configuration set forth above, it is possible to simplify production steps.

A configuration in which the production method of the energy harvester 1 includes a first barrier layer 14 stacking step in which the first barrier layer 14 and the first conductive substrate layer 2 are stacked and a second barrier layer 15 stacking step in which the second barrier layer 15 and the second conductive substrate layer 5 are stacked, in which the sealing step is performed after the first barrier layer 14 stacking step and after the second barrier layer 15 stacking step, and in which the energy harvester 1 includes the first barrier layer 14, the first conductive substrate layer 2, the current collector layer 3, the sealing material layer 4, the second conductive substrate layer 5, and the second barrier layer 15 in stated order may be adopted. Through the configuration set forth above, it is possible to simplify production steps.

The present disclosure is not limited to the embodiment described above and various alterations can be made to the extent that they do not deviate from the essence of the present disclosure.

Accordingly, the energy harvester 1 of the embodiment described above can be altered so long as it is an energy harvester 1 including a first conductive substrate layer 2, a current collector layer 3, a sealing material layer 4, and a second conductive substrate layer 5 in stated order, wherein the energy harvester 1 includes a power generation section 6 that includes a peripheral portion 6a formed by the first conductive substrate layer 2, the current collector layer 3, the sealing material layer 4, and the second conductive substrate layer 5 and that converts energy of an external environment to electrical power and an output section 7 that is disposed outside of the power generation section 6 and that is formed by the first conductive substrate layer 2 and the current collector layer 3, and the output section 7 includes a first portion 3a of the current collector layer 3 where electrical power from the power generation section 6 is supplied, a second portion 3b of the current collector layer 3 that is separated from the first portion 3a, an electronic component 8 that electrically connects the first portion 3a and the second portion 3b, and a sealing material 9 that seals the electronic component 8.

### INDUSTRIAL APPLICABILITY

According to the present disclosure, it is possible to provide an energy harvester 1 that enables the provision of an electronic component 8 in an output section 7 while also restricting thickness of the energy harvester 1 and also to provide a method of producing the same.

### REFERENCE SIGNS LIST

1 energy harvester
2 first conductive substrate layer
3 current collector layer
3a first portion
3b second portion
4 sealing material layer
5 second conductive substrate layer
6 power generation section
6a peripheral portion
7 output section
8 electronic component
9 sealing material
10 output electrode
11 metal layer
12 power-generating cell group
12a first power-generating cell row
12b second power-generating cell row
13 current-collecting material
14 first barrier layer
15 second barrier layer
16 hole
17 adhesive layer

## Claims

1. An energy harvester comprising a first conductive substrate layer, a current collector layer, a sealing material layer, and a second conductive substrate layer in stated order, wherein
the energy harvester includes:
a power generation section that includes a peripheral portion formed by the first conductive substrate layer, the current collector layer, the sealing material layer, and the second conductive substrate layer and that converts energy of an external environment to electrical power; and
an output section that is disposed outside of the power generation section and that is formed by the first conductive substrate layer and the current collector layer, and
the output section includes a first portion of the current collector layer where the electrical power from the power generation section is supplied, a second portion of the current collector layer that is separated from the first portion, an electronic component that electrically connects the first portion and the second portion, and a sealing material that seals the electronic component.

2. The energy harvester according to claim 1, wherein the second conductive substrate layer is disposed such as to not overlap with the electronic component in a stacking direction.

3. The energy harvester according to claim 1, wherein the electronic component inhibits reverse flow of electrical current between the first portion and the second portion of the current collector layer.

4. The energy harvester according to claim 3, wherein the electronic component is a diode.

5. The energy harvester according to claim 1, wherein the sealing material is continuously formed using the same material in the sealing material layer.

6. The energy harvester according to claim 1, wherein
the output section includes a pair of output electrodes formed by the current collector layer, and
at least one of the output electrodes is formed by the second portion of the current collector layer and a metal layer that is stacked on the second portion of the current collector layer such as to be positioned at an opposite side to the first conductive substrate layer.

7. The energy harvester according to claim 6, wherein
a first barrier layer, the first conductive substrate layer, the current collector layer, the sealing material layer, the second conductive substrate layer, and a second barrier layer are included in stated order, and
the sealing material, the second conductive substrate layer, and the second barrier layer are disposed such as to not overlap with at least part of the metal layer of each of the output electrodes in a stacking direction.

8. The energy harvester according to claim 1, wherein the power generation section converts light energy of the external environment to the electrical power.

9. The energy harvester according to claim 1, wherein
an adhesive layer is stacked between the electronic component and the first portion of the current collector layer and between the electronic component and the second portion of the current collector layer, and
the adhesive layer electrically connects the electronic component to the first portion of the current collector layer and the second portion of the current collector layer.

10. The energy harvester according to claim 9, wherein the adhesive layer is formed by an anisotropic conductive film.

11. A method of producing the energy harvester according to any one of claims 1 to 10, comprising sealing in which the sealing material layer and the sealing material are continuously formed using the same material.

12. The method according to claim 10, comprising electronic component arrangement in which the electronic component is electrically connected to the first portion of the current collector layer and the second portion of the current collector layer, wherein
the sealing is performed after the electronic component arrangement.

13. The method according to claim 11, comprising:
first barrier layer stacking in which a first barrier layer and the first conductive substrate layer are stacked; and
second barrier layer stacking in which a second barrier layer and the second conductive substrate layer are stacked, wherein
the sealing is performed after the first barrier layer stacking and after the second barrier layer stacking, and
the energy harvester includes the first barrier layer, the first conductive substrate layer, the current collector layer, the sealing material layer, the second conductive substrate layer, and the second barrier layer in stated order.
